# EUROPÄISCHE PATENTSCHRIFT

(11) **EP 1 129 492 B1**
(45) Veröffentlichungstag und Bekanntmachung des Hinweises auf die Patenterteilung: **09.04.2014**
(21) Anmeldenummer: 99945905.0
(22) Anmeldetag: 05.07.1999
(51) Int. Cl.: H01L 33/00

(54) **OBERFLÄCHENEMITTIERENDE DIODENSTRAHLUNGSQUELLE**
SURFACE-EMITTING DIODE RADIATION SOURCE
SOURCE DE RAYONNEMENT DE DIODE A EMISSION PAR LA SURFACE

(30) Priorität: 30.09.1998 DE 19844971
(43) Veröffentlichungstag der Anmeldung: 05.09.2001
(73) Patentinhaber: OSRAM Opto Semiconductors GmbH, 93055 Regensburg (DE)
(72) Erfinder: AMANN, Markus-Christian, D-80935 München (DE)
(74) Vertreter: Epping - Hermann - Fischer
(86) Internationale Anmeldenummer: PCT/DE1999/002064
(87) Internationale Veröffentlichungsnummer: WO 2000/019545

(56) Entgegenhaltungen:
- EP-A- 0 260 110
- WO-A-85/02722
- GB-A- 2 087 145
- PATENT ABSTRACTS OF JAPAN vol. 013, no. 005 (E-701), 9. Januar 1989 (1989-01-09) -& JP 63 216389 A (NEC CORP), 8. September 1988 (1988-09-08)

## Beschreibung

Die Erfindung betrifft eine Oberflächenemittierende Diodenstrahlungsquelle mit einer aktiven Schicht zur Erzeugung optischer Strahlung, die zwischen einer Confinementschicht aus Halbleitermaterial eines Leitfähigkeitstyps und einer Confinementschicht aus Halbleitermaterial eines zum einen Leitfähigkeitstyp entgegengesetzten Leitfähigkeitstyps liegt, wobei die erzeugte Strahlung eine in der Strahlungsquelle sich in einer Richtung senkrecht zu einer Schichtebene der aktiven Schicht ausbreitende Strahlungskomponente und eine sich in einer Richtung parallel zu dieser Schichtebene ausbreitende Strahlungskomponente aufweist und wobei die Strahlungsquelle eine zur Schichtebene der aktiven Schicht parallele Oberfläche aufweist, aus der die sich in der Richtung im wesentlichen senkrecht zu dieser Schichtebene ausbreitende Strahlungskomponente austritt.

Ein Beispiel einer derartigen oberflächenemittierende Diodenstrahlungsquelle ist eine Leuchtdiode (LED). Derartige LEDs mit hoher Intensität und großer Modulationsbandbreite werden üblicherweise in der Up-side down Aufbautechnik hergestellt, wobei z.B. bei einer typischen LED-Struktur im InGaAsP/InP-Materialsystem eine Confinementschicht aus InP des Leitfähigkeitstyps n auf einem Substrat aus InP des gleichen Leitfähigkeitstyps n aufgebracht ist, die andere Confinementschicht aus InP des entgegengesetzten Leitfähigkeitstyps p besteht und eine von der aktiven Schicht aus InGaAsP und der einen Confinementschicht sowie dem Substrat abgekehrte Oberfläche aufweist, die flächig mit einem p-Kontakt kontaktiert ist. Eine von den Confinementschichten und der aktiven Schicht abgekehrten Oberfläche des Substrats ist mit einem n-Kontakt kontaktiert, der eine Öffnung aufweist, in der diese Oberfläche freiliegt und durch welche die sich in der Richtung senkrecht zur Schichtebene der aktiven Schicht ausbreitende Strahlungskomponente aus der LED austritt.

Eine hohe Strahlungsleistung für die sich in Richtung senkrecht zur Schichtebene der aktiven Schicht ausbreitende und aus der Oberfläche der LED austretende Strahlungskomponente kann nur mit einer undotierten aktiven Schicht erzielt werden, da Dotieratome in der aktiven Schicht zusätzliche nichtstrahlende Rekombinationsprozesse ermöglichen.

Da andererseits die Modulationsbandbreite durch eine hohe Dotierung, z.B. 2 x 10¹⁸cm⁻³, erheblich gesteigert werden kann, ist es nicht möglich, nur durch geeignete Dotierung gleichzeitig hohe Bandbreiten und Strahlungsleistungen zu erzielen.

Zur Lösung dieses Problems bei der LED wurde vorgeschlagen, möglichst dünne aktive Schichten, z.B. Schichten mit einer Dicke von 0,3 µm bei 1,3 µm dicken LEDs aus InGaAsP/InP, innerhalb einer Doppelheterostruktur zu verwenden, um durch die hohe Ladungsträgerinjektion die strahlende Rekombinationsrate zu erhöhen ohne die Schicht zu dotieren. Dieser Ansatz löst das Problem nur teilweise, denn bei hohen Strömen ergeben sich deutlich niedrigere Strahlungsleistungen für die sich in Richtung senkrecht zur Schichtebene der aktiven Schicht ausbreitende und aus der Oberfläche der LED austretende Strahlungskomponente als erwartet.

Ein anderes Beispiel einer oberflächenemittierenden Diodenstrahlungsquelle der eingangs genannten Art ist eine Laserdiode.

Bei einer solchen Laserdiode wird zur Erzielung einer hohen Strahlungsleistung der sich in der Richtung senkrecht zur Schichtebene der aktiven Schicht ausbreitenden und aus der Oberfläche der Laserdiode austretenden Strahlungskomponente eine große Abmessung der aktiven Schicht in Richtung parallel zu deren Schichtebene von z.B. einigen 10 µm benötigt. Dadurch besteht das Problem, dass auch die Emission in dieser Richtung verstärkt wird, so dass der Wirkungsgrad sinkt.

Bei einer oberflächenemittierenden Laserdiode kann durch Anordnung vieler Einzellaser in einem Array eine höhere Gesamtleistung der sich in der Richtung senkrecht zur Schichtebene der aktiven Schicht ausbreitenden und aus der Oberfläche der Laserdiode austretenden Strahlungskomponente erzielt werden.

In der Druckschrift JP 63-216389 A ist eine oberflächenemittierende Diode beschrieben.

Der Erfindung liegt die Aufgabe zugrunde, aufzuzeigen, wie bei einer oberflächenemittierenden Diodenstrahlungsquelle der eingangs genannten Art die Strahlungsleistung der sich in der Richtung senkrecht zur Schichtebene der aktiven Schicht ausbreitenden und aus der Oberfläche der Diode austretenden Strahlungskomponente erhöht werden kann.

Diese Aufgabe wird durch die im Anspruch 1 angegebene Diodenstrahlungsquelle gelöst.

Gemäß dieser Lösung ist bei dieser Diodenlichtquelle eine Schwächungseinrichtung zu einer Schwächung der sich in der Richtung parallel zur Schichtebene der aktiven Schicht ausbreitenden Strahlungskomponente vorhanden. Die Schwächungseinrichtung erstreckt sich parallel zur Schichtebene der aktiven Schicht über den gesamten Querschnitt der Quelle.

Bei einer bevorzugten Ausgestaltung der erfindungsgemäßen Quelle weist die Schwächungseinrichtung eine in einer Confinementschicht ausgebildete und sich in der zur Schichtebene der aktiven Schicht parallelen Richtung erstreckende Schicht aus strahlungsabsorbierenden Material auf.

Eine Schicht aus strahlungsabsorbierendem Material kann auf beiden Seiten der aktiven Schicht vorhanden sein. Eine Schicht aus strahlungsabsorbierendem Material sollte ausreichend nahe bei der aktiven Schicht angeordnet sein.

Die Schwächungseinrichtung kann alternativ dazu oder zusätzlich in der zur Schichtebene der aktiven Schicht parallelen Richtung aufeinanderfolgende Strahlungsablenkstellen und/oder Strahlungsstreustellen zum jeweiligen Ablenken eines Strahlunganteils der sich in dieser parallelen Richtung ausbreitenden Strahlungskomponente aus dieser Richtung in eine Richtung im wesentlichen senkrecht zur Schichtebene der aktiven Schicht aufweisen.

Strahlungsablenkstellen und/oder Strahlungsstreustellen können in oder in Nähe der aktiven Schicht angeordnet sein. Durch sie wird die sich in der zur Schichtebene der aktiven Schicht parallelen Richtung ausbreitende Strahlungskomponente gestreut und gedämpft. Damit kann das Auftreten von ungünstiger starker verstärkter spontaner Emission oder ASE (= Amplified Spontaneous Emission) verhindert werden ohne dass die Oberflächenemission beeinflusst wird.

Bei der erfindungsgemäßen Quelle liegt vorteilhafterweise eine gleichzeitige Optimierung von Lichtleistung und Bandbreite vor. Überdies sind vorteilhafterweise bei der erfindungsgemäßen Quelle in dem Fall, dass sie als LED ausgebildet ist, die oben in Bezug auf die LED geschilderten Probleme, und in dem Fall, dass sie als Laserdiode ausgebildet ist, die oben in Bezug auf die Laserdiode geschilderten Probleme gelöst.

Bei einer als LED ausgebildeten erfindungsgemäßen Quelle kann, da die ASE durch die Schwächungseinrichtung in der zur Schichtebene der aktiven Schicht parallelen Richtung unterdrückt wird, vorteilhafterweise eine dünne aktive Schicht verwendet werden, um eine hohe Bandbreite zu erzielen.

Ausführungsbeispiele der Erfindung werden in der nachfolgenden Beschreibung anhand der Zeichnung beispielhaft näher erläutert. Es zeigen:
- Figur 1: einen Schnitt durch ein eine Schicht aus strahlungsabsorbierendem Material aufweisendes Ausführungsbeispiel der erfindungsgemäßen Quelle senkrecht zur Schichtebene der laseraktiven Schicht und in schematischer Darstellung,
- Figur 2: einen Schnitt durch ein Ablenk- und/oder Streustellen aufweisendes Ausführungsbeispiel der erfindungsgemäßen Quelle senkrecht zur Schichtebene der laseraktiven Schicht und in schematischer Darstellung, und
- Figur 3: ein Diagramm, in welchem die Strahlungsleistung der sich senkrecht zur Schichtebene der laseraktiven Schicht ausbreitenden und aus der Oberfläche der erfindungsgemäßen Quelle austretenden Strahlungskomponente gegen einen Diodenstrom durch diese Quelle sowohl mit als auch ohne ASE aufgetragen ist.

Die Figuren sind nicht maßstäblich.

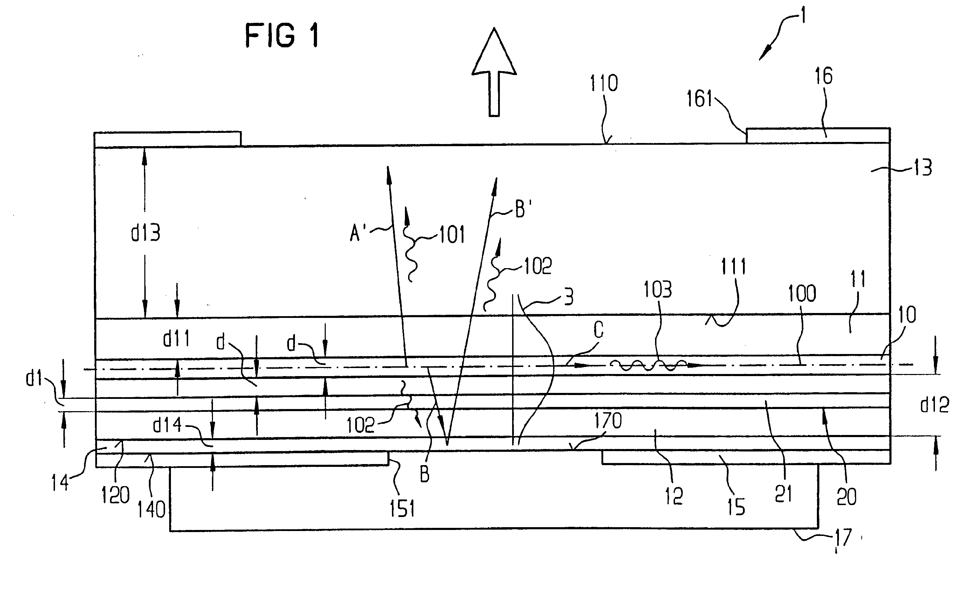

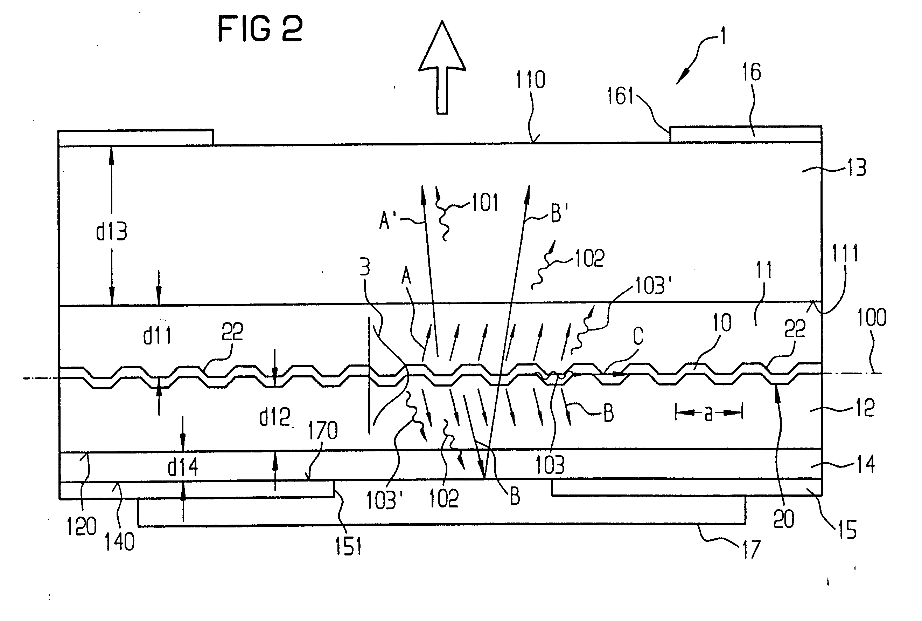

Die in den Figuren 1 und 2 dargestellten Ausführungsbeispiele der generell mit 1 bezeichnen oberflächenemittierenden Diodenstrahlungsquelle weisen jeweils eine aktive Schicht 10 zur Erzeugung optischer Strahlung 101, 102, 103 auf, die zwischen einer Confinementschicht 11 aus beispielsweise n-dotiertem Halbleitermaterial und einer Confinementschicht 12 aus in diesem Fall p-dotiertem Halbleitermaterial auf. Es könnte prinzipiell auch so sein, dass die Confinementschicht 11 p-dotiert und die Confinementschicht 12 n-dotiert ist.

Die erzeugte Strahlung 101, 102, 103 weist eine in der Strahlungsquelle 1 sich in einer Richtung A senkrecht zu einer Schichtebene 100 der aktiven Schicht 10 ausbreitende Strahlungskomponente 101, eine in der Strahlungsquelle 1 in einer zur Richtung A entgegengesetzten und ebenfalls zur Schichtebene 100 senkrechten Richtung B sich ausbreitende Strahlungskomponente 102 und eine sich in einer Richtung C parallel zu dieser Schichtebene 100 ausbreitende Strahlungskomponente 103 auf.

Die Richtung A weist von der aktiven Schicht 10 fort zur Oberfläche 110, die Richtung B weist von der aktiven Schicht 10 und der Oberfläche 110 fort. Die Richtung C ist eigentlich eine Doppelrichtung, da sich die betreffende Strahlungskomponente 103 nicht nur und wie in den Figuren 1 und 2 dargestellt nach rechts, sondern auch in der entgegengesetzten Richtung nach links ausbreitet.

Überdies weist die Strahlungsquelle 1 eine zur Schichtebene 100 der aktiven Schicht 10 parallele Oberfläche 110 auf, bei der die sich in der Richtung A ausbreitende Strahlungskomponente 101 aus der Quelle 1 austritt.

In beiden beispielhaften Fällen ist die Oberfläche 110 eine von der aktiven Schicht 10 und den Confinementschichten 11 und 12 abgekehrte Oberfläche eines Substrats 13 mit einer von dieser Oberfläche 110 ab- und der aktiven Schicht 10 und den Confinementschichten 11 und 12 zugekehrten Oberfläche 111, auf der die Confinementschicht 11 aufgebracht ist.

Das Substrat 13 besteht aus einem Halbleitermaterial des gleichen Leitfähigkeitstyps wie dem der Confinementschicht 11, im Beispiel des Typs n. Auf der Oberfläche 110 des Substrats 13 ist eine einen elektrischen Kontakt für den Leitfähigkeitstyp des Substrats 13 bildende Schicht 16 aus einem Metall aufgebracht, die eine Öffnung 161 aufweist, in der die Oberfläche 110 des Substrats 13 zum Austritt der sich in der Richtung A ausbreitenden Strahlungskomponente 101 aus der Quelle 1 von der Schicht 16 freigelegt ist.

Die andere Confinementschicht 12 weist beispielsweise eine von der aktiven Schicht 10 abgekehrte Oberfläche 120 auf, auf der eine Kontaktschicht 14 aus einem relativ zu dieser Confinementschicht 12 höher dotierten Halbleitermaterial des gleichen Leitfähigkeitstyps wie dem der Confinementschicht 12, im Beispiel des Typs p aufgebracht ist.

Auf einer von der aktiven Schicht 10 und der Confinementschicht 12 abgekehrten Oberfläche 140 der Kontaktschicht 14 ist eine Schicht 15 aus elektrisch isolierendem Material mit einer Öffnung 151 aufgebracht, in der die Oberfläche 140 der Kontaktschicht 14 von der Schicht 15 freigelegt ist und mit einem Kontakt 17 aus einem Metall für den Leitfähigkeitstyp der Kontaktschicht 14, im Beispiel für den Typ p kontaktiert ist.

Es liegt bei beiden beispielhaften Fällen auch die vorteilhafte Besonderheit vor, dass der Kontakt 17 eine mit der Oberfläche 140 der Kontaktschicht 14, in der Öffnung 151 in Kontakt stehende und der Confinementschicht 12 und der aktiven Schicht 10 zugekehrte spiegelnde Oberfläche 170 aufweist. Diese Oberfläche 170 reflektiert den auf sie treffenden Anteil der sich in der Richtung B ausbreitenden Strahlungskomponente 102 in Richtung B' zur aktiven Schicht 10 und durch diese Schicht 10 hindurch zur Oberfläche 110 und zum Austritt aus der Quelle 1. Die Richtung B' ähnlich wie die Richtung A senkrecht zur Schichtebene 100 der aktiven Schicht 10.

Die Quelle 1 weist eine Schwächungseinrichtung 20 zu einer Schwächung der sich in der Richtung C parallel zur Schichtebene 100 der aktiven Schicht 10 ausbreitenden Strahlungskomponente 103 auf. Diese Maßnahme kann die für die Strahlungsleistung der in Richtung A, B senkrecht zur Schichtebene 100 der aktiven Schicht 10 sich ausbreitenden Strahlungskomponenten 101 und 102 ungünstige ASE in der zur Schichtebene 100 der aktiven Schicht 10 parallelen Richtung C zumindest vermindert werden.

Der Grund für den ungünstigen Einfluss der ASE ist, dass bei den hohen Injektionsdichten, die für eine effektive Reduktion der strahlenden Ladungsträgerlebensdauer benötigt werden, optische Verstärkung auftritt. Diese führt zu der verstärkter spontaner Emission oder ASE in der Richtung parallel zur Schichtebene 100 der aktiven Schicht 10, wodurch die Ladungsträgerdichte aufgrund der stimulierten Emission reduziert wird und letztendlich die Strahlungsleistung P der sich in Richtung A, B' senkrecht zur Schichtebene 100 der aktiven Schicht 10 ausbreitenden und aus der Oberfläche 110 der Quelle 1 austretenden Strahlungskomponenten 101, 102 zugunsten einer Emission in der Richtung C parallel zur Schichtebene 100 der aktiven Schicht 10 verringert wird. Die ASE nimmt dabei mit zunehmendem Durchmesser des Leuchtflecks überproportional zu. Rechnerisch - ließen sich je nach Struktur bis ca. 50 % höhere Strahlungsleistungen erzielen, wenn die ASE vermieden werden könnte.

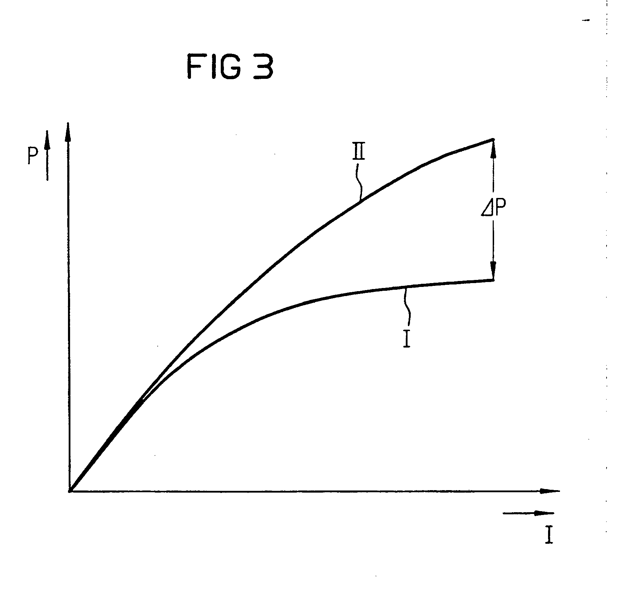

In der Figur 3 ist die Strahlungsleistung P der sich in Richtung A, B' senkrecht zur Schichtebene 100 der aktiven Schicht 10 ausbreitenden und aus der Oberfläche 110 der Quelle 1 austretenden Strahlungskomponenten 101, 102 als Funktion des durch die Quelle 1 fließenden Diodenstroms I für eine Quelle 1 in Form einer Standard-LED dargestellt. Die Kurve I gibt die Strahlungsleistung P dieser LED mit ASE, die Kurve II die Strahlungsleistung P dieser LED ohne ASE als Funktion des Diodenstroms I an. AP ist der Leistungsverlust durch die ASE in der zur Schichtebene 100 der aktiven Schicht 10 parallelen Richtung C.

Bei der beispielhaften Quelle 1 nach Figur 1 weist die Schwächungseinrichtung 20 eine in einer Confinementschicht ausgebildete und sich in der zur Schichtebene 100 der aktiven Schicht 10 parallelen Richtung C erstreckende Schicht 21 aus strahlungsabsorbierendem Material auf.

Beispielsweise ist die Schicht 21 in der Confinementschicht 12 angeordnet. Ein Abstand d zwischen der aktiven Schicht 10 und der Schicht 21 und eine Dicke d1 der Schicht 21 werden so gewählt, dass die in der Richtung C geführten transversalen Moden ein hohes Confinement in dieser Schicht 21 aufweisen und damit stark gedämpft werden. Die örtliche Intensitätsverteilung in Richtung senkrecht zur Schichtebene 100 der aktiven Schicht 10 der in der Richtung C parallel zur Schichtebene 100 sich ausbreitenden Strahlungskomponente 103 ist durch die Kurve 3 angedeutet.

Wenn die Schicht 21 in der Confinementschicht 12 angeordnet ist, wird die Oberflächenemission nur insoweit beeinflusst, als die sich zunächst in der Richtung B und nach Reflexion an der Fläche 170 in der Richtung B' ausbreitende Strahlungskomponente 102 gedämpft wird. Die in der Richtung A sich ausbreitende Strahlungskomponente 101 wird nicht beeinflusst.

Die Dämpfung der sich in den Richtungen B, B' ausbreitenden Strahlungskomponente 102 lässt sich minimieren, indem die Dicke d1 der Schicht 21 und der Abstand d zwischen dieser Schicht 21 und der aktiven Schicht 10 jeweils möglichst klein gewählt werden, d.h. ein großer Confinement-Faktor und eine hohe Absorption in der Richtung C gegeben sind.

Eine andere, besonders elegante Möglichkeit ist es, die Schicht 21 so zwischen der aktiven Schicht 10 und der Kontaktschicht 14 in der Confinementschicht 12 anzuordnen, dass eine durch die reflektierende Fläche 170 des Kontaktes 17 erzeugte stehende optische Welle in der Schicht 21 ein Minimum aufweist.

Bei einer konkreten Ausführung der Quelle 1 nach Figur 1 in Form einer LED für eine Emissionswellenlänge λ von 1,3 µm weist das Substrat 13 eine Dicke von 100 µm auf und besteht aus InP einer Gap-Wellenlänge λ_{g} von 0,92 µm und einer n-Dotierung von 10¹⁸ cm⁻³.

Die Confinementschicht 11 weist eine Dicke d11 von 1 µm bis 2 µm, vorzugsweise 1 µm oder 0,1 µm auf und besteht aus InP einer Gap-Wellenlänge λ_{g} von 0,92 µm und einer n-Dotierung von 5x10¹⁷ cm⁻³.

Die aktive Schicht 10 weist eine Dicke d10 von 0,1 µm bis 1 µm, vorzugsweise 0,3 µm auf und besteht aus InGaAsP einer Gap-Wellenlänge λ_{g} von 1,30 µm und einer p-Dotierung von 0x10¹⁸ cm⁻³ bis 2x10¹⁸ cm⁻³.

Der Abstand d der Schicht 21 von der aktiven Schicht 10 beträgt 0,1 µm bis 0,3 µm, vorzugsweise 0,2 µm. Die Schicht 21 selbst weist eine Dicke d1 von 0,05 µm bis 0,1 µm, vorzugsweise 0,1 µm oder 0,05 µm auf.

Die zwischen der aktiven Schicht 10 und der Kontaktschicht 14 gemessene Gesamtdicke d12 der die Schicht 21 enthaltenden Confinementschicht 12 beträgt 0,65 µm und 3,4 µm, vorzugsweise 1,3 µm.

Die Confinementschicht 12 besteht aus InP einer Gap-Wellenlänge λ_{g} von 0,92 µm und einer p-Dotierung von 10¹⁸ cm⁻³.

Die Schicht 21 besteht aus InGaAs einer Gap-Wellenlänge λ_{g} von 1,67 µm und einer p-Dotierung von 2x10¹⁸ cm⁻³.

Die Kontaktschicht 14 weist eine Dicke d14 von 0,05 µm bis 0,3 µm, beispielsweise 0,1 µm auf und besteht aus InGaAs einer Gap-Wellenlänge λ_{g} von 1,67 µm und einer p-Dotierung von 10²⁰ cm⁻³.

Das in der Figur 2 dargestellte Beispiel der Quelle 1 unterscheidet sich vom Beispiel nach Figur 1 im Wesentlichen dadurch, dass die Schwächungseinrichtung 20 in der zur Schichtebene 100 der aktiven Schicht 10 parallelen Richtung C aufeinanderfolgende Strahlungsablenkstellen und/oder Strahlungsstreustellen 22 zum jeweiligen Ablenken eines Strahlunganteils 103' der sich in dieser parallelen Richtung C ausbreitenden Strahlungskomponente 103 aus dieser Richtung C in eine Richtung A, B senkrecht zur Schichtebene 100 der aktiven Schicht 10 aufweist.

Solche Strahlungsablenkstellen und/oder Strahlungsstreustellen 22 können in der Richtung C kontinuierlich oder, wie in der Figur 2 gezeigt, mit einem Abstand a voneinander aufeinanderfolgend anzuordnen. Beispielsweise kann der Abstand a gleich etwa 10 µm betragen.

Die Stellen 22 selbst können beispielsweise durch Einbau von Inhomogenitäten in oder in der Nähe der aktiven Schicht 10 hergestellt und so ausgebildet sein, dass sie strahlungsreflektierend und/oder -streuend wirken.

Eine Schicht aus strahlungsabsorbierendem Material wie die Schicht 21 des Beispiels nach Figur 1 ist bei diesem Beispiel nach Figur 2 nicht vorhanden. Dadurch kann vorteilhafterweise das Auftreten von starker ASE verhindert werden, ohne dass die Oberflächenemission beeinflusst wird.

Die Quelle 1 nach Figur 1 oder 2 kann jeweils auch in Form eines oberflächenemittierenden Lasers ausgeführt sein, bei dem die Schwächungsfunktion 20 in gleicher Weise wie bei der LED wirkt. Auch hier können beispielsweise eine oder mehrere, dünne Schichten 21 aus strahlungsabsorbierendem Material in Minima der vertikalen Feldverteilung gelegt werden. Aufgrund der hohen Reflexion von Bragg-Reflektoren in solchen Lasern sind die Minima stark ausgeprägt und eine Absorption der Oberflächenemission kann daher vernachlässigt werden.

## Patentansprüche

1. Oberflächenemittierende Diodenstrahlungsquelle (1), mit
- einer aktiven Schicht (10) zur Erzeugung optischer Strahlung (101, 102, 103), die zwischen
- einer Confinementschicht (11) aus Halbleitermaterial eines Leitfähigkeitstyps (n; p), und
- einer Confinementschicht (12) aus Halbleitermaterial eines zum einen Leitfähigkeitstyp (n; p) entgegengesetzten Leitfähigkeitstyps (p; n) liegt, wobei
- die erzeugte Strahlung (101, 102, 103) eine in der Strahlungsquelle (1) sich in einer Richtung (A, B) senkrecht zu einer Schichtebene (100) der aktiven Schicht (10) ausbreitende Strahlungskomponente (101, 102) und eine sich in einer Richtung (C) parallel zu dieser Schichtebene (100) ausbreitende Strahlungskomponente (103) aufweist, wobei
- die Strahlungsquelle (1) eine zur Schichtebene (100) der aktiven Schicht (10) parallele Oberfläche (110) aufweist, aus der die sich in der Richtung (A, B) senkrecht zu dieser Schichtebene (100) ausbreitende Strahlungskomponente (101, 102) austritt,
- eine Schwächungseinrichtung (20) zu einer Schwächung der sich in der Richtung (C) parallel zur Schichtebene (100) der aktiven Schicht (10) ausbreitenden Strahlungskomponente (103) vorhanden ist,
**dadurch gekennzeichnet, dass** sich die Schwächungseinrichtung (20) parallel zur Schichtebene (100) der aktiven Schicht (10) über den gesamten Querschnitt der Quelle erstreckt.

2. Quelle nach Anspruch 1, wobei die Schwächungseinrichtung (20) eine in einer Confinementschicht (12, 11) ausgebildete und sich in der zur Schichtebene (100) der aktiven Schicht (10) parallelen Richtung (C) erstreckende Schicht (21) aus strahlungsabsorbierendem Material aufweist.

3. Quelle nach Anspruch 1 oder 2, wobei die Schwächungseinrichtung (20) in der zur Schichtebene (100) der aktiven Schicht (10) parallelen Richtung (C) aufeinanderfolgende Strahlungsablenkstellen (22) zum jeweiligen Ablenken eines Strahlunganteils (103') der sich in dieser parallelen Richtung (C) ausbreitenden Strahlungskomponente (103) aus dieser Richtung (C) in eine Richtung (A, B) senkrecht zur Schichtebene (100) der aktiven Schicht (10) aufweist.

4. Quelle nach einem der vorhergehenden Ansprüche, wobei die Schwächungseinrichtung (20) in der zur Schichtebene (100) der aktiven Schicht (10) parallelen Richtung (C) aufeinanderfolgende Strahlungsstreustellen (22) zum jeweiligen Streuen eines Strahlunganteils (103') der sich in dieser parallelen Richtung (C) ausbreitenden Strahlungskomponente (103) aus dieser Richtung (C) in eine Richtung (A, B) senkrecht zur Schichtebene (100) der aktiven Schicht (10) aufweist.

5. Quelle nach einem der vorhergehenden Ansprüche, wobei die Quelle auf der Seite, die von der Oberfläche (110), aus der die sich senkrecht zur Schichtebene (100) der aktiven Schicht (10) ausbreitenden Strahlungskomponenten (101, 102) austreten, abgewandt ist, mit einem Kontakt (17) versehen ist, der auf der der aktiven Schicht (10) zugewandten Seite eine spiegelnde Oberfläche aufweist.

6. Quelle nach einem der vorhergehenden Ansprüche, wobei die Schwächungseinrichtung (20) auf der Seite der aktiven Schicht angeordnet ist, die von der Oberfläche (110), aus der die sich senkrecht zur Schichtebene (100) der aktiven Schicht (10) ausbreitenden Strahlungskomponenten (101, 102) austreten, abgewandt ist.

## Claims

1. Surface emitting diode radiation source (1), comprising
- an active layer (10) for generating optical radiation (101, 102, 103), which lies between
- a confinement layer (11) composed of semiconductor material of one conductivity type (n; p) and
- a confinement layer (12) composed of semiconductor material of an opposite conductivity type (p; n) relative to said one conductivity type (n; p), wherein
- the generated radiation (101, 102, 103) has a radiation component (101, 102) propagating in the radiation source (1) in the direction (A, B) perpendicular to a layer plane (100) of the active layer (10) and a radiation component (103) propagating in a direction (C) parallel to said layer plane (100), wherein
- the radiation source (1) has a surface (110) parallel to the layer plane (100) of the active layer (10), from which surface the radiation component (101, 102) propagating in the direction (A, B) perpendicular to said layer plane (100) emerges,
- an attenuating device (20) for attenuating the radiation component (103) propagating in the direction (C) parallel to the layer plane (100) of the active layer (10) is present,
**characterized in that**
the attenuating device (20) extends parallel to the layer plane (100) of the active layer (10) over the entire cross section of the source.

2. Source according to claim 1, wherein the attenuating device (20) has a layer (21) composed of radiation-absorbing material, said layer being formed in a confinement layer (12, 11) and extending in the direction (C) parallel to the layer plane (100) of the active layer (10).

3. Source according to claim 1 or 2, wherein the attenuating device (20) has, in the direction (C) parallel to the layer plane (100) of the active layer (10), successive radiation deflecting locations (22) for respectively deflecting a radiation portion (103') of the radiation component (103) propagating in this parallel direction (C) from this direction (C) to a direction (A, B) perpendicular to the layer plane (100) of the active layer (10).

4. Source according to any of the preceding claims, wherein the attenuating device (20) has, in the direction (C) parallel to the layer plane (100) of the active layer (10), successive radiation scattering locations (22) for respectively scattering a radiation portion (103') of the radiation component (103) propagating in this parallel direction (C) from this direction (C) to a direction (A, B) perpendicular to the layer plane (100) of the active layer (10).

5. Source according to any of the preceding claims, wherein, on the side facing away from the surface (110) from which the radiation components (101, 102) propagating perpendicularly to the layer plane (100) of the active layer (10) emerge, the source is provided with a contact (17) having a specularly reflective surface on the side facing the active layer (10).

6. Source according to any of the preceding claims, wherein the attenuating device (20) is arranged on the side of the active layer which faces away from the surface (110) from which the radiation components (101, 102) propagating perpendicularly to the layer plane (100) of the active layer (10) emerge.

## Revendications

1. Source (1) de rayonnement à diode émettant en surface, la source présentant :
une couche active (10) qui forme un rayonnement optique (101, 102, 103) et disposée entre
une couche de confinement (11) en matériau semiconducteur d'un type de conductivité (n; p) et
une couche de confinement (12) en matériau semiconducteur d'un type de conductivité (p; n) opposé au type de conductivité (n; p),
le rayonnement (101, 102, 103) formé présentant une composante (101, 102) qui se propage dans la source de rayonnement (1) dans une direction (A, B) perpendiculaire à un plan (100) de la couche active (10) et une composante (103) qui se propage dans une direction (C) parallèle à ce plan (100) de couche,
la source de rayonnement (1) présentant une surface (110) parallèle au plan (100) de la couche active (10) et depuis laquelle la composante de rayonnement (101, 102) se propage dans la direction (A, B) perpendiculaire à ce plan (100) de la couche,
un dispositif d'atténuation (20) qui atténue la composante de rayonnement (103) qui se propage dans la direction (C) parallèle au plan (100) de la couche active (10) étant prévu,
**caractérisée en ce que**
le dispositif d'atténuation (20) s'étend parallèlement au plan (100) de la couche active (10) sur toute la section transversale de la source.

2. Source selon la revendication 1, dans laquelle le dispositif d'atténuation (20) présente une couche (21) en matériau absorbant le rayonnement, formée dans une couche de confinement (12, 11) et s'étendant dans la direction (C) parallèle au plan (100) de la couche active (10).

3. Source selon les revendications 1 ou 2, dans laquelle le dispositif d'atténuation (20) présente dans la direction (C) parallèle au plan (100) de la couche active (10) des emplacements (22) de déviation du rayonnement qui dévient chacun une partie (103') du rayonnement de la composante de rayonnement (103) qui se propage dans cette direction parallèle (C) depuis cette direction (C) jusque dans une direction (A, B) perpendiculaire au plan (100) de la couche active (10).

4. Source selon l'une des revendications précédentes, dans laquelle le dispositif d'atténuation (20) présente dans la direction (C) parallèle au plan (100) de la couche active (10) des emplacements (22) successifs de diffusion du rayonnement qui diffusent chacun une partie (103') du rayonnement de la composante de rayonnement (103) qui se propage dans cette direction parallèle (C) depuis cette direction (C) jusque dans une direction (A, B) perpendiculaire au plan (100) de la couche active (10).

5. Source selon l'une des revendications précédentes, dans laquelle sur le côté non tourné vers la surface (110) de laquelle la composante (101, 102) du rayonnement qui se propage perpendiculairement au plan (100) de la couche active (10), la source est dotée d'une contact (17) qui présente une surface réfléchissante sur le côté tourné vers la couche active (10).

6. Source selon l'une des revendications précédentes, dans laquelle le dispositif d'atténuation (20) est disposé sur le côté de la couche active qui n'est pas tourné vers la surface (110) de laquelle sortent les composantes (101, 102) du rayonnement qui se propagent perpendiculairement au plan (100) de la couche active (10).
